# EUROPEAN PATENT SPECIFICATION

(11) **EP 2 813 132 B1**
(45) Date of publication and mention of the grant of the patent: **11.04.2018**
(21) Application number: 13746884.9
(22) Date of filing: 06.02.2013
(51) Int. Cl.: H05K 3/46, H05K 1/18, H01L 23/12

(54) **MULTILAYER ELECTRONICS ASSEMBLY AND METHOD FOR EMBEDDING ELECTRICAL CIRCUIT COMPONENTS WITHIN A THREE DIMENSIONAL MODULE**
MEHRSCHICHTIGE ELEKTRONISCHE ANORDNUNG UND VERFAHREN ZUM EINBETTEN VON ELEKTRISCHEN SCHALTELEMENTEN IN EINEM DREIDIMENSIONALEN MODUL
ENSEMBLE ÉLECTRONIQUE MULTICOUCHE ET PROCÉDÉ PERMETTANT D'INTÉGRER DES COMPOSANTS DE CIRCUIT ÉLECTRIQUE DANS UN MODULE TRIDIMENSIONNEL

(30) Priority: 08.02.2012 US 201261596652 P; 04.02.2013 US 201313758543
(43) Date of publication of application: 17.12.2014
(73) Proprietor: Crane Electronics, Inc., Redmond, Washington 98052 (US)
(72) Inventor: PARKER, Ernest, Clyde, Mill Creek, Washington 98012 (US); LAURIELLO, Philip, Joseph, Holmdel, New Jersey 07733 (US)
(74) Representative: Hanna Moore + Curley
(86) International application number: PCT/US2013/024907
(87) International publication number: WO 2013/119643

(56) References cited:
- EP-A1- 0 446 656
- WO-A1-98/39105
- WO-A1-2011/040502
- WO-A2-2010/110626
- JP-A- H05 144 973
- JP-A- 2001 024 333
- JP-A- 2007 251 076
- JP-A- 2009 141 197
- US-A- 5 087 585
- US-A- 5 329 695
- US-A1- 2006 044 735
- US-A1- 2008 017 409

## Description

### BACKGROUND

### Technical Field

The present disclosure relates to a multilayer electronics assembly and an associated method of manufacture.

### Description of the Related Art

Conventionally, multilayer printed circuit boards using epoxy fiberglass (FR4), fluoropolymer composites (such as polytetrafluoroethylene, PTFE), or mixed dielectric (MDk, a combination of FR4 and PTFE) have been used to route signals to components that are mounted on the surface of a multilayer structure. These multilayer printed circuit boards most commonly include traces that are etched copper as one means of routing signals to components. For these circuits, resistors can be screen-printed or etched. These multilayer printed circuit board assemblies can be used in a variety of applications including, among others, RF and power electronics modules. As one example, these technologies can form multifunction modules (MFM) which carry monolithic microwave integrated circuits (MMICs) on their surface.

In another conventional method, multilayer integrated circuits and microwave, multifunction modules, are constructed of multiple layers of fluoropolymer composite substrates that are bonded together into a multilayer structure by utilizing a fusion bonding process. The composite substrate material can be PTFE filled with glass fibers and ceramic. These multilayer structures may include thin film resistors that are screen printed or etched into the individual layers prior to the fusion process. For example, resistors can be etched into thin nickel phosphate films adjacent to copper layers, using a method that is similar to copper etching.

Certain discrete electrical circuit components, for example discrete devices, such as passive discrete resistors, capacitors, magnetic devices, and active semiconductor devices, are not merely thin films created by etching or screen printing. Instead, these discrete devices are attached to a substrate with, for example, a solder paste that cannot withstand the heat and/or pressure of the fusion bonding process. To incorporate such discrete electrical circuit components into a multilayer integrated assembly, the conventional method includes forming cavities in individual substrate layers, attaching the discrete electrical circuit components in the cavities, and applying a polymer bonding film layer as a separate, post-fusion bonding step. For example, U.S. Patent No. 6,009,677 to Logothetis et al. and U.S. Patent No. 6,395,374 to McAndrews et al. describe a process for manufacturing a multilayer structure of fusion bonded fluoropolymer composite substrates in which discrete electrical circuit components are attached post-bonding within cavities formed in the multilayer structure, and then covered with a film bonded layer.

US 2008/017409 describes a multi-layered board incorporating an electronic device that includes an electrode made of a material having a melting point higher than a temperature of the heating process that is used to electrically connect a plurality of interlayer connectors to a conductor pattern. WO 2011/040502 describes a circuit substrate comprising a laminate containing a built-in electronic part, the laminate being formed by stacking insulation films of a flexible material, which will not cause circuit disconnection between the electronic part and the electrically connected terminal electrode. WO 2010/110626 describes a composition for a conductive paste containing micrometer-thick silver microplates (or plate-shaped silver micro particles) surface-modified with metal nano particles. WO 98/39105 describes how conductive traces made from transient liquid phase sintering (TLPS) pastes, plated by electroless or electrolytic means, result in improved solderability, adhesion and conductivity of circuitry. EP O 446 656 and US 5 329 695 describe methods of fabricating multilayer circuits.

### BRIEF SUMMARY

It has been observed that a multilayer electronics assembly can be achieved by using a bonding material to attach the discrete components that: (1) has a processing temperature for attaching discrete components that is lower than a glass transition temperature of the layers of the multilayer structure to which the discrete components are attached, and (2) goes through a state transition following processing to attach the discrete components that results in requiring a significantly higher temperature post-processing in order to change back to a liquid, flowable, or pliable state, in which the post-processing state transition temperature is also substantially higher than the fusion bonding temperature of the substrate layers of the multilayer electronics assembly. Accordingly there is provided an electronics assembly as defined in claim 1. A method of fabricating an electronics assembly is also provided. Advantageous features are in the dependent claims.

The multilayer electronics assembly may further include a second discrete electrical circuit component bonded to a second layer of the plurality of layers. The plurality of substrate layers may be stacked in a first direction, and the first discrete electrical component overlaps the second discrete electrical component in the first direction. The plurality of substrate layers may be stacked in a first direction, and the first discrete electrical circuit component may be positioned between adjacent layers of the plurality of stacked substrate layers. The substrate layers may include a fluoropolymer composite. The bonding material may be nanosilver sintered solder. The bonding material may be a transient liquid phase bonded alloy. The first discrete electrical circuit component may be one of a passive discrete resistor, a capacitor, a magnetic device, and an active semiconductor device.

A multilayer electronics module may be summarized as including a three dimensional, unitary block of a first material having a reflow point, at which the bonding material becomes flowable, at a first temperature; and a plurality of discrete electrical circuit components embedded within the unitary block, each of the plurality of discrete electrical circuit components bonded to the block by a second material having a melting point at a second temperature that is higher than the first temperature.

The unitary block may include an exterior surface defined by a top surface, a bottom surface, and a plurality of side surfaces, and the first material may completely surround at least a first one of the plurality of discrete electrical components such that the first material is positioned between all sides of the first one of the plurality of discrete electrical components and any point on the exterior surface of the unitary block. The first material may not directly contact the first one of the plurality of discrete electrical components. The plurality of discrete electrical circuit components may include a first discrete electrical circuit component, a second discrete electrical circuit component, and a third discrete electrical circuit component, the first discrete electrical circuit component overlaps the second discrete electrical circuit component in a first direction, and the first discrete electrical circuit component overlaps the third discrete electrical circuit component in a second direction that is perpendicular to the first direction. The first material may be a fluoropolymer composite. The second material may be nanosilver sintered solder. The first material may be a transient liquid phase bonded alloy. The plurality of discrete electrical circuit components may be selected from a group consisting of a passive discrete resistor, a capacitor, a magnetic device, and an active semiconductor device.

A multifunction module may be summarized as including a primary substrate, a power semiconductor die bonded to the primary substrate; a plurality of secondary substrates stacked on the primary substrate and fusion bonded to each other, a first discrete electrical circuit component bonded to a first substrate of the plurality of secondary substrates with a first material that has a first melting point that is higher than a fusion bonding temperature of the substrate layers, and a second discrete electrical circuit component bonded to a second substrate of the plurality of secondary substrates with a second material that has a second melting point that is higher than the fusion bonding temperature of the substrate layers; and an active electronic component attached to an external surface of one of the plurality of secondary substrates that is positioned furthest from the primary substrate. The first material may be the same as the second material.

A method of embedding discrete electrical circuit components within a multilayer module may be summarized as attaching a first discrete electrical circuit component to a first substrate via a first bonding material that is initially flowable at a first temperature thereby causing the bonding material to go through a state transition such that, once the bonding material hardens, the bonding material will not return to a flowable state until a second temperature, which is higher than the first temperature, is reached, the first temperature is lower than a fusion bonding temperature of the first substrate, and the second temperature is higher than the fusion bonding temperature of the first substrate; attaching a second discrete electrical circuit component to a second substrate via the bonding material; and fusion bonding the first substrate to the second substrate.

Attaching the first discrete electrical circuit component to the first substrate may include nanosilver sintering the first discrete electrical circuit component to the first substrate. Attaching the first discrete electrical circuit component to the first substrate may include transient liquid phase bonding the first discrete electrical circuit component to the first substrate.

A multilayer electronics assembly may be summarized as including a plurality of substrate layers stacked in first direction, each of the plurality of substrate layers bonded to at least an adjacent one of the plurality of substrate layers; a bonding material having an initial transition temperature at which the bonding material becomes initially flowable, and a subsequent transition temperature at which the bonding material subsequently becomes flowable after hardening following the initially becoming flowable, the initial transition temperature lower than the subsequent transition temperature; a first discrete electrical circuit component bonded to a first layer of the plurality of layers with a bonding material, the bonding material; and a second discrete electrical circuit component bonded to a second layer of the plurality of layers with the bonding material, the second discrete electrical component overlaps the first discrete electrical component in the first direction.

In the multilayer electronics assembly, the bonding material is a solid immediately prior to the subsequent transition temperature being reached. The substrate layers may include at least one of epoxy fiberglass and polyamide. The bonding material may be nanosilver sintered solder or a transient liquid phase bonded alloy. The first discrete electrical circuit component may be one of a passive discrete resistor, a capacitor, a magnetic device, and an active semiconductor device.

A method of embedding discrete electrical circuit components within a multilayer module is summarized as including attaching a first discrete electrical circuit component to a first substrate via a bonding material at a first temperature thereby causing the bonding material to go through a state transition such that the bonding material will not return to a flowable state until a second temperature, which is higher than the first temperature, is reached; attaching a second substrate to the first substrate; and attaching a second discrete electrical circuit component to the second substrate via the bonding material at the first temperature.

### BRIEF DESCRIPTION OF THE SEVERAL VIEWS OF THE DRAWINGS

In the drawings, identical reference numbers identify similar elements or acts. The sizes and relative positions of elements in the drawings are not necessarily drawn to scale. For example, the shapes of various elements and angles are not drawn to scale, and some of these elements are arbitrarily enlarged and positioned to improve drawing legibility. Further, the particular shapes of the elements as drawn, are not intended to convey any information regarding the actual shape of the particular elements, and have been solely selected for ease of recognition in the drawings.
Figure 1A is an exploded, pictorial view of a multilayer electronics assembly.
Figure 1B is a pictorial view of the multilayer electronics assembly of Figure 1A in a partially assembled state.
Figure 2 is a side view of a multilayer electronics assembly prior to fusion bonding.
Figures 3A-3F illustrate several sequential acts for embedding discrete electrical circuit components within a multilayer module.
Figure 4 illustrates one example temperature profile for nanosilver sintering.
Figure 5 illustrates a flow chart of several sequential acts for embedding discrete electrical circuit components within a multilayer module.

### DETAILED DESCRIPTION

### I. System Overview

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known structures associated with electrical circuits, including discrete electrical components such discrete electronic components, and/or printed circuit boards including insulative substrates and conductive traces and vias have not been shown or described in detail to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to."

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

The headings and Abstract of the Disclosure provided herein are for convenience only and do not interpret the scope or meaning of the embodiments.

For the purposes of the present disclosure, the phrase "discrete electrical circuit component" is intended to include discrete electrical circuit components, including electronic components which are formed separately from the printed circuit board and are thus selectively placeable thereon or attachable thereof, and exclude thin film elements that are formed as part of forming the printed circuit board as screen printed or etched directly into the traces of individual layers of a multilayer module (i.e. resistors that are etched into thin nickel phosphate films adjacent to copper layers, using a method that is similar to copper etching).

As discussed above, conventional fusion bonded multilayer modules do not support embedding discrete electrical circuit components within the module due to the inability of conventional device attachment methods to survive the temperature/pressure of fusion bonding. Instead, the conventional fusion bonding method includes forming cavities in individual substrate layers, attaching the discrete electrical circuit components in the cavities, and applying a polymer bonding film layer as a separate, post-fusion bonding step. This technique adds process steps, does not provide as good of protection for the discrete electrical circuit components (particularly bare semiconductor die), and does not support as high of density of packaging in a three dimensional module. For example, only one discrete electrical circuit component can be placed in a given horizontal (X-Y) location in a cavity, and devices cannot be stacked or overlap within the vertical (Z) dimension. Further, discrete electrical circuit components that are placed within cavities and then covered by an additional layer or layers cannot be electrically connected to the additional covering layer(s) unless additional post-fusion drilling or etching and plating is performed. In addition, the immunity to moisture ingress is limited by the integrity of the bonding film that is applied as a post-fusion step, instead of the integrity of the unitary structure formed through fusion bonding.

The techniques of the present disclosure may provide improved packaging density and performance for electronic products, particularly for microwave and power applications, when compared with the conventional method. Specifically, the present disclosure describes a method for embedding discrete electrical circuit components, both active and passive devices, three dimensionally within a fusion bonded multilayer module. The resulting assembly achieves higher density and potentially better performance due to reduced circuit parasitics, particularly for circuits operating with high frequency, high di/dt, or dv/dt, compared to non-integrated (e.g., surface mount, non-three dimensional) solutions.

As discussed in greater detail below, the discrete electrical circuit components are attached using a device attachment method that has a process temperature compatible with discrete electrical circuit components and the composite module fusion bonding temperature and a re-melt temperature significantly above the composite module fusion bonding temperature. For example, a bonding material can be used that has an initial transition temperature at which the bonding material becomes initially flowable, and a subsequent transition temperature at which the bonding material subsequently becomes flowable after hardening following initially becoming flowable. The initial transition temperature is lower than the subsequent transition temperature

For example, as discussed in greater detail below, a device attachment technique such as nanosilver sintering or transient liquid phase bonding are used to attach the discrete electrical circuit components to the substrate layers prior to fusion bonding. Each of these device attach methods shares the characteristic that: (1) the process temperature is less than the substrate and discrete electrical circuit component rated temperatures for soldering (or alternative device attachment) and (2) the resulting bonding material has a significantly higher re-melt or reflow temperature than conventional solder and is greater than the composite substrate fusion temperature.

### II. Hardware

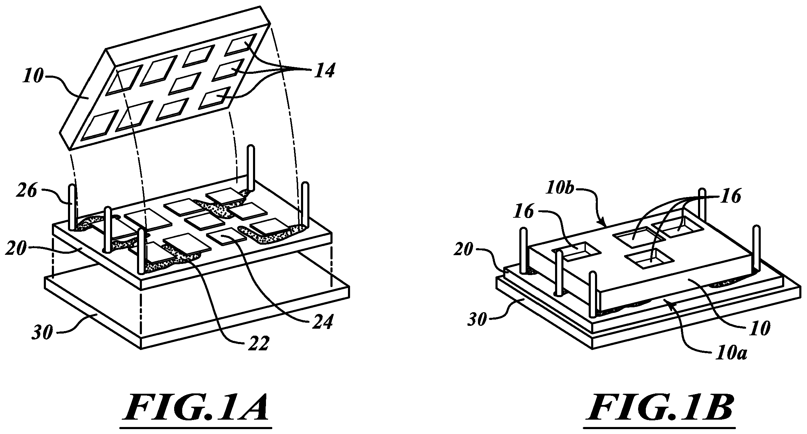

Figures 1A and 1B are simplified representations of a multilayer electronics assembly incorporated into a device according to one example. Figure 1A shows exploded view of the major sub-assemblies of the device. The subassemblies include a multilayer electronics assembly 10, base substrate 20, and a heat-sink 30.

In this example, the base substrate 20 can be an aluminum nitride (AIN) direct bonded copper (DBC) substrate that includes a plurality of conductive traces 22 (such as, for example, copper traces) on a top surface thereof, a plurality of bare die 24 (such as, for example, power Metal Oxide Semiconductor Field Effect Transistors, MOSFETs) bonded to the top surface thereof, and a plurality of interconnecting posts 26 extending from the top surface thereof.

The multilayer electronics assembly 10 includes discrete electrical circuit components embedded therein in three dimensions. As discussed in greater detail below, the multilayer electronics assembly 10 is formed by a fusion bonding process in which the discrete electrical circuit components are bonded to the internal layers of the assembly prior to fusion bonding. A plurality of cavities 14 are formed on a bottom surface of the multilayer electronics assembly 10 to accommodate the bare die 24 on the substrate 20. As shown in Figure 1B, the multilayer electronics assembly 10 also includes a plurality of cavities 16 on a top surface thereof to accommodate higher profile parts that are attached using surface mount technology. Thus, active components can be attached on a top side, at 10b, of the multilayer electronics assembly 10 or on a bottom side, at 10a, of the multilayer electronics assembly 10.

In one example, the bare die 24 on the substrate 20 are attached to the multilayer electronics assembly 10 with a nanosilver sintering technique. For example, a nanosilver sintered solder paste can be used within the cavities 14. In this example, nanosilver sintering is achieved with a temperature profile that ramps to approximately 180°C to bake out the binder within the nanosilver paste and then raises the temperature to approximately 280°C for 10 minutes to sinter the nanosilver particles. The resulting interfacial "solder" joint has a significantly lower thermal and electrical resistance than conventional lead or lead-free solder, improved integrity in the presence of repeated thermal cycling induced stress, and, a solder joint that will not 'reflow' until > 900°C. This latter property allows post-processing that potentially includes exposure to the fusion bonding process of the multilayer electronics assembly 10 and post-process soldering of top-side components without reflow of the power semiconductor solder joints.

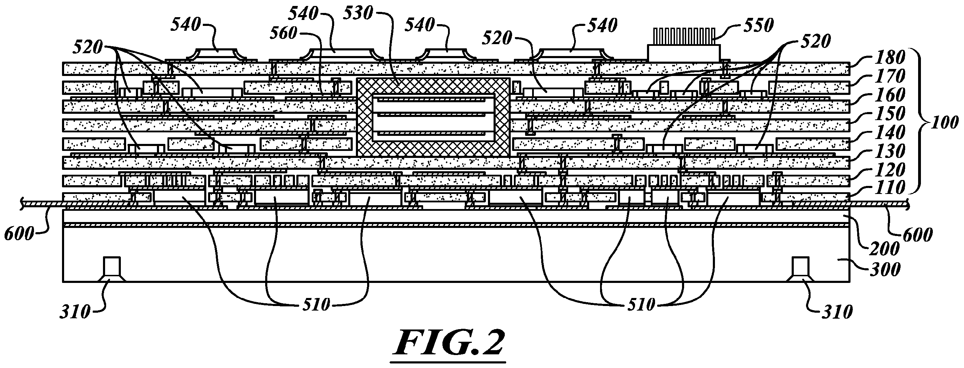

As noted above, the discrete electrical circuit components of the multilayer electronics assembly 10 are bonded to the internal layers of the assembly prior to fusion bonding. Figure 2 shows a more detailed side view of an example multilayer electronics assembly prior to fusion bonding.

Starting from the bottom of the assembly, a first layer 300 is a heat-sink. In this example, the heat-sink 300 can be cast to support a variety of thermal interface options, e.g., solid with mounting holes 310 for conduction, channels for liquid (not shown), or pin fin/slotted fins (not shown) for cooling air.

A second layer is a base layer 200 shown in this example with copper on each side. As with the base substrate 20, the base layer 200 can be an aluminum nitride (AIN) direct bonded copper (DBC) substrate. The base layer 200 can be attached to the heat-sink 300 by epoxy, solder (nanosilver sintered solder, or, if the heat-sink is attached after the fusion bonding process, standard solder), or, if the base layer 200 is not clad with copper on the side facing the heat sink, fusion bonding (either separately or as a single act for the whole assembly). A plurality of power semiconductor dies 510, such as MOSFETs, are placed with either side down to the base layer 200 in order to facilitate an optimal circuit layout. As discussed in greater detail below, these semiconductor dies 510 can be attached to the base layer 200 and a multilayer electronics assembly 100 using a device attachment technique such as nanosilver sintering or transient liquid phase bonding.

The multilayer electronics assembly 100 is arranged above the base layer 200. A first (lowest) layer 110 of the multilayer electronics assembly 100 can act as a spacer and interconnect layer between top and bottom sides of the semiconductor dies 510. A plurality of layers 120, 130, 140, 150, 160, 170, and 180 are stacked above the first layer 110. These layers can include discrete electronic components 520, 530, and 560 bonded thereto by a device attachment technique such as nanosilver sintering or transient liquid phase bonding. The discrete electronic components 520 can be, for example, passive discrete resistors, capacitors, a magnetic device, or an active semiconductor device. Surface mount techniques can be used to add further components 540 and 550 topside. The device can include a power interconnect 600, which can be, for example, a flat copper ribbon interconnect for supplying power to the device.

The dielectric properties of a fluoropolymer composite such as polytetrafluoroethylene (PTFE) filled with glass and ceramic can contribute to a multilayer structure including power electronics that is well suited for radiofrequency applications. However, as noted above, the scope of the present disclosure is not limited to the use of PTFE as a substrate material.

Likewise, the present disclosure is not solely limited to fusion bonded assemblies. For example, it is also possible to create a multilayer module with three dimensionally embedded discrete electrical circuit components by utilizing layers made of printed wire board (PWB) materials such as using epoxy fiberglass (FR4) or polyamide. The layers can be assembled using, for example a controlled adhesive, such as a reinforcement material pre-impregnated with a resin matrix (a "prepreg"), can be directly assembled with nanosilver sintering, can be directly assembled via transient liquid phase bonding, or can be assembled using a combination of these techniques. In the case of direct assembly with nanosilver sintering or transient liquid phase bonding, the layers could be spaced a sufficient amount to allow outgassing during processing. An encapsulant could then be used to seal gaps between layers, if environmental exposure is a concern.

Nanosilver sintering or transient liquid phase bonding makes it possible to attach devices to an individual layer and then subsequently sinter one layer to another without worrying about the previously attached devices becoming detached due to the heat required to attach subsequent devices. For example, the bonding material (in the case of nanosilver sintering or transient liquid phase bonding) for the devices goes through a state transition following processing to attach the devices that results in requiring a significantly higher temperature post-processing in order to change back to a liquid, flowable, or pliable state. This post-processing state transition temperature is also substantially higher than the temperature required to initially attach the devices. The resulting structure would include discrete electrical circuit components that are three dimensionally embedded within a multilayer module without requiring the creation of cavities in the layers post assembly.

### III. Method of Manufacture

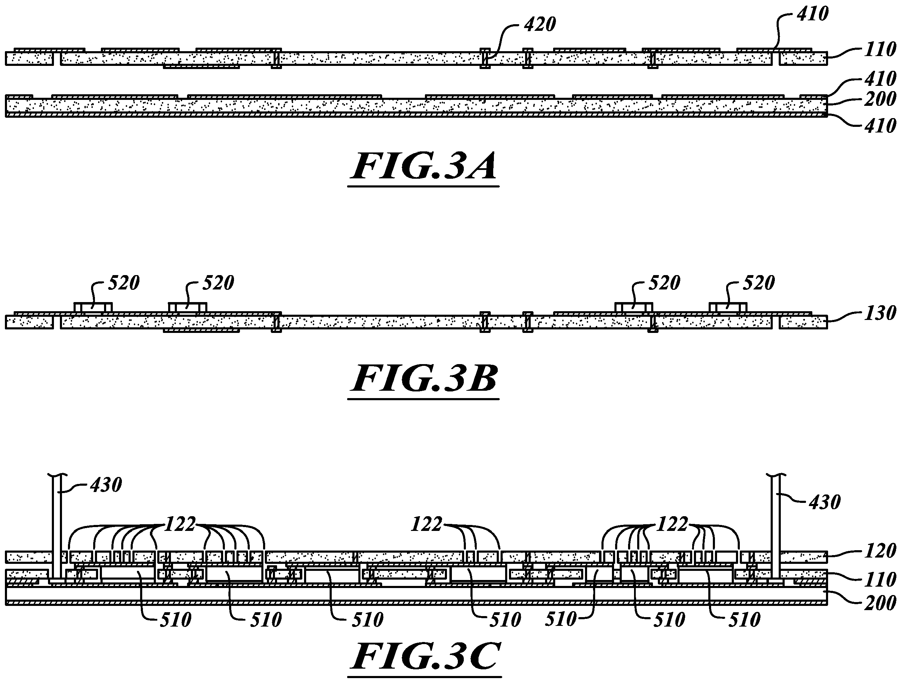

Several acts for embedding discrete electrical circuit components three dimensionally within a multilayer module are hereinafter described with references to Figures 3A-3F, 4, and 5.

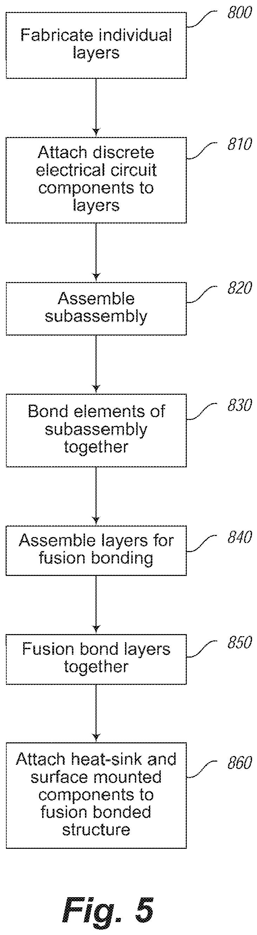

In a first act, 800 in Figure 5, the individual layers of the multilayer electronics assembly are fabricated. For example, Figure 3A illustrates the layers 110 and 200. A layer 110 can be a fluoropolymer composite (such as polytetrafluoroethylene, PTFE) filled with glass and ceramic. The base layer 200 includes a conductor 410, such as copper on either side. As noted above, the base layer 200 can be a direct bond copper substrate formed of an AIN board. For layers where nanosilver sintering is to be used for device attachment, the surface final finish can be gold or silver. As shown in Figure 3A, the individual layers can include vias 420, that allow for connectivity between layers.

In a second act, 810 in Figure 5, discrete electrical circuit components are attached to the individual layers. For example, Figure 3B illustrates discrete electrical circuit components 520, which can be passive elements such as resistors and capacitors, or small signal active devices, attached to an individual layer 130. The discrete electrical circuit components 520 can be bonded to the layer 130 using nanosilver sintering or transient liquid phase bonding. One example of transient liquid phase bonding is described in "Highly Reliable Nickel-Tin Transient Liquid Phase Bonding Technology for High Temperature Operational Power Electronics in Electrified Vehicles", by Sang Won Yoon, Satoshi Yasuda, Michael D. Glover, Koji Shiozaki. An example of nanosilver sintering is described in International Publication No. WO 2005/079353.

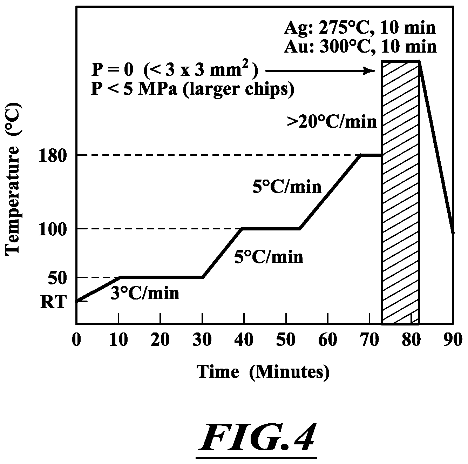

In the present example, the discrete electrical circuit components 520 are attached to the individual layer 130 by nanosilver sintering, using the temperature profile shown in Figure 4. In this example, no pressure is used for die attachment of components that are smaller than 10 mm x 10 mm.

In a third act, 820 in Figure 5, a subassembly is assembled for bonding. For example, Figure 3C illustrates the assembly of layers 110 and 120 with the base layer 200 and the power semiconductor die 510. The interconnecting posts 430 assist with the alignment of the layers. In this example, nanosilver solder paste is silkscreened onto each of layers 110, 120, and 200. For example, a 50 µm thick layer of nanosilver is silkscreened on and allowed to air dry. Then a 10 µm layer of nanosilver is applied, the power semiconductor die 510 are put in place, and the layers 200, 110, and 120 are arranged in preparation for the sintering process. Layer 120 is shown with vent holes 122 drilled above and or around the periphery of the power semiconductor die 510. These vent holes 122 allow the solvents and binder in the nanosilver solder paste to escape during the sintering process.

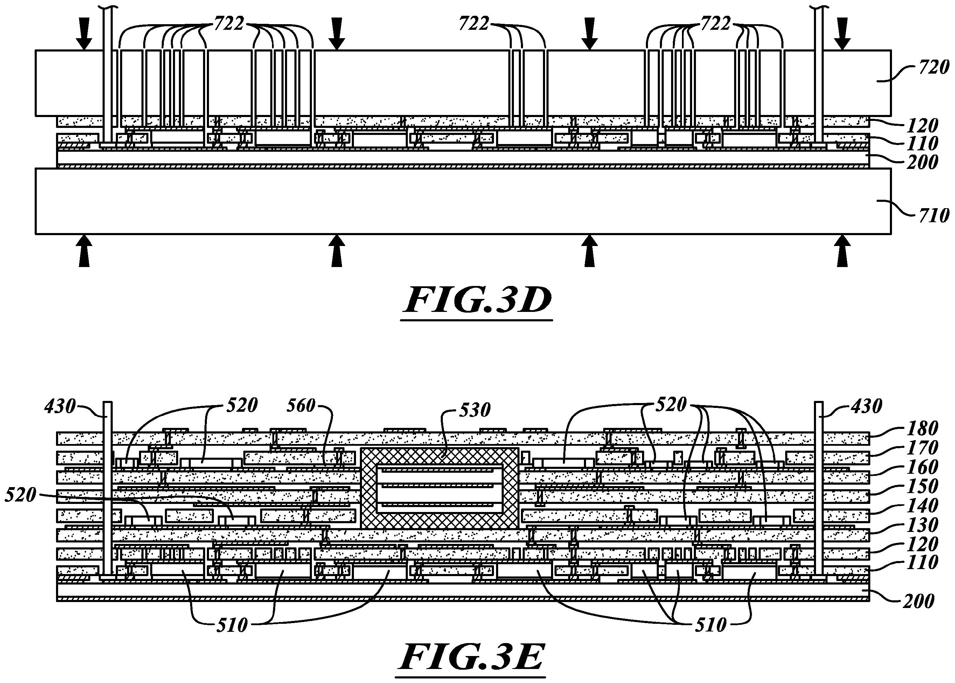

Next, as shown at 830 in Figure 5, the elements of the subassembly are bonded together. For example, as shown in Figure 3D, pressure is applied with plates 710 and 720. Plate 720 includes vent holes 722 aligned with the vent holes 122 in the layer 120. The pressure is applied to ensure that solvents are baked out from underneath the die and the vent holes 722 allow the gas to escape. In this example, approximately 3-5 MPa is used for the nanosilver sintering process when die of greater than 10 mm x 10 mm are used. The profile in this example is essentially the same as shown in Figure 4, except that pressure is applied at the 180°C, 10 minute portion of the profile (and as/if needed during ramp up to 180°C). Pressure can then be removed before taking up to 275/300°C.

Next, as shown at 840 in Figure 5, the layers are assembled for fusion bonding. For example, as shown in Figure 3E, the remaining layers 130, 140, 150, 160, 170, and 180 are stacked along with the sub-assembly of layers 110, 120, and 200 that are now sintered together. These layers are then fusion bonded (850, Figure 5). Fusion bonding is typically accomplished in an autoclave or hydraulic press by heating substrate layers past the PTFE composite melting point while simultaneously applying a determined amount of pressure, preferably mechanically, isostatically, or a combination of both. The alignment of layers is typically secured by a precision fixture with a plurality of pins (such as the interconnecting posts 430 in the present example), preferably three to eight but possibly more, to stabilize flow as the PTFE resin changes state to a viscous liquid and adjacent layers fuse under pressure. Depending on the size of the stack being bonded, the pin arrangement for alignment of the stack is preferably triangular or rectangular. The pins themselves are preferably round, square, rectangular, oval, or diamond-shaped, but may have other shapes.

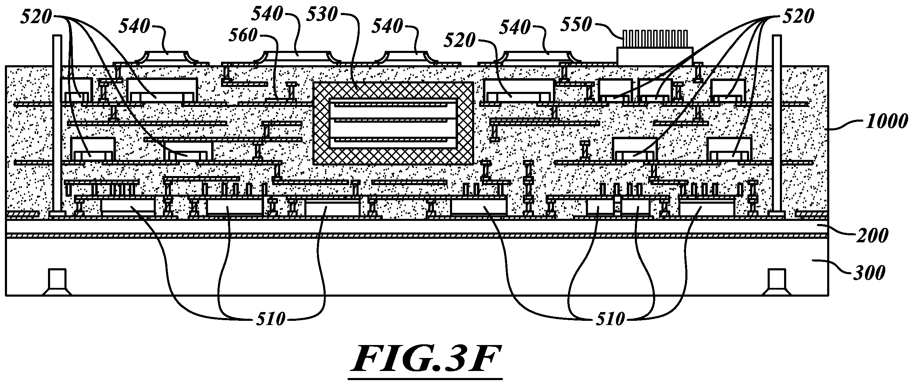

Because the discrete electrical circuit components 510, 520, and 560 were attached to the respective layers by nanosilver sintering or transient liquid phase bonding, the discrete electrical circuit components 510, 520, and 560 are able to remain bonded to the conductive paths in the module during the fusion bonding process. For example, the melting temperature of an alloy formed by transient liquid phase bonding and the melting point of the bond formed nanosilver sintering far exceed the temperature required to achieve a PTFE composite melting point for fusion bonding. The resulting three dimensional, unitary, multilayer electronics module 1000 is depicted in Figure 3F. The multilayer electronics module 1000 includes a plurality of discrete electrical circuit components 510, 520, and 560 embedded three dimensionally within the fusion bonded block. Unlike conventional multilayer, fusion bonded modules, the module 1000 in Figure 3F, includes discrete electrical circuit components stacked in layers such that the discrete electrical circuit components overlap within the vertical dimension. In addition, the discrete electrical circuit components are electrically connected to surrounding layers without the need for additional post-fusion drilling and plating. Further, immunity to moisture ingress is supported by the integrity of the unitary structure formed through fusion bonding.

After fusion bonding is performed, the heat-sink and the top-side surface mount components are attached (860, Figure 5). For example, as shown in Figure 3F, the heat-sink 300 is attached below the multilayer electronics module 1000, and top-side surface mount technology parts 540 and 550 are attached to a top surface of the multilayer electronics module 1000. A low thermal resistance can be achieved by fusion bonding the heat-sink 300 to the base layer 200, if the base layer 200 is not clad with copper on the side facing the heat sink. In one example, this can be achieved as part of the fusion bonding act discussed with reference to Figure 3E. In this case, the heat-sink 300 can be designed with a 'web' matrix between modules to facilitate cutting the modules apart. This cutting may be achieved with water jet cutting. In another example, the heat-sink 300 can be AlSiC cast in sectional modules held together by the Al skin so that only the Al skin needs to be cut. In another example, the heat-sink 300 could be soldered to the assembly illustrated in Figure 3E, or bonded thereto.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A multilayer electronics assembly, comprising:
a plurality of stacked substrate layers, each of the plurality of substrate layers fusion bonded to at least an adjacent one of the plurality of substrate layers;
a first discrete electrical circuit component bonded to a first layer of the plurality of layers using a bonding material interposed between the discrete electrical circuit component and the first layer and forming an interfacial solder joint having a reflow temperature > 900 °C, the reflow temperature at which the bonding material becomes flowable being higher than each of an initial flow temperature of the bonding material and a fusion bonding temperature of the substrate layers, the initial flow temperature of the bonding material being the temperature at which the bonding material became flowable to bond the discrete electrical circuit component and the first layer prior to fusion bonding of the substrate layers;
a plurality of vent holes (122) configured to operably allow gases to escape during a bonding of the first discrete electrical component and the first layer.

2. The multilayer electronics assembly according to claim 1, further comprising:
a second discrete electrical circuit component bonded to a second layer of the plurality of layers.

3. The multilayer electronics assembly according to claim 2, wherein the plurality of substrate layers are stacked in a first direction, and the first discrete electrical component overlaps the second discrete electrical component in the first direction.

4. The multilayer electronics assembly according to claim 1, wherein the plurality of substrate layers are stacked in a first direction, and the first discrete electrical circuit component is positioned between adjacent layers of the plurality of stacked substrate layers.

5. The multilayer electronics assembly according to claim 1, wherein the substrate layers include a fluoropolymer composite.

6. The multilayer electronics assembly according to claim 1, wherein the bonding material is a solid immediately prior to the reflow temperature being reached.

7. The multilayer electronics assembly according to claim 1, wherein the bonding material is nanosilver sintered solder.

8. The multilayer electronics assembly according to claim 1, wherein the bonding material is a transient liquid phase bonded alloy.

9. The multilayer electronics assembly according to claim 1, wherein the first discrete electrical circuit component is one of a passive discrete resistor, a capacitor, a magnetic device, and an active semiconductor device.

10. The multilayer electronics assembly according to claim 1 wherein one of the plurality of stacked substrate layers is a primary substrate, a power semiconductor is die bonded to the primary substrate, and the other substrate layers are stacked on the primary substrate, and wherein an active electronic component is attached to an external surface of one of the plurality of substrate layers that is positioned furthest from the primary substrate.

11. The multilayer electronics assembly according to claim 10 wherein the bonding material interposed between the discrete electrical circuit component and the first layer is a first material that has a first melting point that is higher than the fusion bonding temperature of the substrate layers, and wherein the multilayer electronics assembly further comprises a second discrete electrical circuit component bonded to a second layer of the plurality of substrate layers with a second material that has a second melting point that is higher than the fusion bonding temperature of the substrate layers.

12. A method of embedding discrete electrical circuit components within a multilayer module, comprising:
attaching a first discrete electrical circuit component to a first substrate via a bonding material that is initially flowable at a first temperature thereby causing the bonding material to go through a state transition such that, once the bonding material hardens, the bonding material will not return to a flowable state until a second temperature, which is higher than the first temperature, is reached, the first temperature is lower than a fusion bonding temperature of the first substrate, and the second temperature is > 900 °C and higher than the fusion bonding temperature of the first substrate;
attaching a second discrete electrical circuit component to a second substrate via the bonding material;
allowing the bonding material to harden, and subsequently
fusion bonding the first substrate to the second substrate.

13. The method of embedding discrete electrical circuit components within a multilayer module according to claim 12, wherein attaching the first discrete electrical circuit component to the first substrate includes nanosilver sintering the first discrete electrical circuit component to the first substrate.

14. The method of embedding discrete electrical circuit components within a multilayer module according to claim 13, wherein attaching the first discrete electrical circuit component to the first substrate includes transient liquid phase bonding the first discrete electrical circuit component to the first substrate.

## Patentansprüche

1. Mehrschichtige elektronische Anordnung, umfassend:
eine Mehrzahl von gestapelten Substratschichten, wobei jede der Mehrzahl von Substratschichten mit mindestens einer angrenzenden der Mehrzahl von Substratschichten schmelzgebunden ist;
ein erstes diskretes elektrisches Schaltelement, das mit einer ersten Schicht der Mehrzahl von Schichten unter Verwendung eines Verbindungsmaterials zwischen dem diskreten elektrischen Schaltelement und der ersten Schicht verbunden ist und eine Grenzflächen-Lötverbindung mit einer Reflow-Temperatur von > 900 °C bildet, wobei die Reflow-Temperatur, bei der das Verbindungsmaterial fließfähig wird, höher als jede der Vorlauftemperaturen des Verbindungsmaterials und der Schmelzverbindungstemperatur der Substratschichten ist, wobei die Vorlauftemperatur des Verbindungsmaterials die Temperatur ist, bei der das Verbindungsmaterial fließfähig wird, um die diskreten elektrischen Schaltelemente und die erste Schicht vor dem Verschmelzen der Substratschichten zu verbinden;
eine Mehrzahl von Lüftungslöchern (122), die derart konfiguriert sind, dass sie Gase während einer Verbindung des ersten diskreten elektrischen Elements mit der ersten Schicht wirksam entweichen lassen.

2. Mehrschichtige elektronische Anordnung nach Anspruch 1, ferner umfassend:
ein zweites diskretes elektrisches Schaltelement, das mit einer zweiten Schicht der Mehrzahl von Schichten verbunden ist.

3. Mehrschichtige elektronische Anordnung nach Anspruch 2, wobei die Mehrzahl von Substratschichten in einer ersten Richtung gestapelt ist und das erste diskrete elektrische Element das zweite diskrete elektrische Element in der ersten Richtung überlappt.

4. Mehrschichtige elektronische Anordnung nach Anspruch 1, wobei die Mehrzahl von Substratschichten in einer ersten Richtung gestapelt ist und das erste diskrete elektrische Schaltelement zwischen angrenzenden Schichten der Mehrzahl von gestapelten Substratschichten positioniert ist.

5. Mehrschichtige elektronische Anordnung nach Anspruch 1, wobei die Substratschichten einen Verbundstoff aus Fluorpolymer beinhalten.

6. Mehrschichtige elektronische Anordnung nach Anspruch 1, wobei das Verbindungsmaterial unmittelbar vor dem Erreichen der Reflow-Temperatur ein Feststoff ist.

7. Mehrschichtige elektronische Anordnung nach Anspruch 1, wobei das Verbindungsmaterial ein Nanosilber-Sinterlot ist.

8. Mehrschichtige elektronische Anordnung nach Anspruch 1, wobei das Verbindungsmaterial eine durch transiente Flüssigphasen verbundene Legierung ist.

9. Mehrschichtige elektronische Anordnung nach Anspruch 1, wobei das erste diskrete elektrische Schaltelement eines von einem passiven diskreten Widerstand, einem Kondensator, einer magnetischen Vorrichtung und einer aktiven Halbleitervorrichtung ist.

10. Mehrschichtige elektronische Anordnung nach Anspruch 1, wobei eine der Mehrzahl von gestapelten Substratschichten ein Primärsubstrat ist, wobei ein Leistungshalbleiter durch Chip-Bonden mit dem Primärsubstrat verbunden ist und die anderen Substratschichten auf dem Primärsubstrat gestapelt sind, und wobei ein aktives elektronisches Element an einer äußeren Oberfläche von einer der Mehrzahl von Substratschichten angebracht ist, die am weitesten vom Primärsubstrat entfernt positioniert ist.

11. Mehrschichtige elektronische Anordnung nach Anspruch 10, wobei das Verbindungsmaterial, das zwischen dem diskreten elektrischen Schaltelement und der ersten Schicht angeordnet ist, ein erstes Material ist, das einen ersten Schmelzpunkt aufweist, der höher als die Schmelzverbindungstemperatur der Substratschichten ist, und wobei die mehrschichtige elektronische Anordnung ferner ein zweites diskretes elektrisches Schaltelement umfasst, das mit einer zweiten Schicht der Mehrzahl von Substratschichten mit einem zweiten Material verbunden ist, das einen zweiten Schmelzpunkt aufweist, der höher als die Schmelzverbindungstemperatur der Substratschichten ist.

12. Verfahren zum Einbetten von diskreten elektrischen Schaltelementen in einem Mehrschichtmodul, umfassend:
Anbringen eines ersten diskreten elektrischen Schaltelements an einem ersten Substrat über ein Verbindungsmaterial, das anfänglich bei einer ersten Temperatur fließfähig ist, wodurch das Verbindungsmaterial einen Zustandsübergang derart durchläuft, dass, sobald das Verbindungmaterial härtet, das Verbindungsmaterial nicht in einen fließfähigen Zustand zurückkehrt, bis eine zweite Temperatur, die höher als die erste Temperatur ist, erreicht ist, wobei die erste Temperatur niedriger als eine Schmelzverbindungstemperatur des ersten Substrats und die zweite Temperatur > 900 °C und höher als die Schmelzverbindungstemperatur des ersten Substrats ist;
Anbringen eines zweiten diskreten elektrischen Schaltelements an einem zweiten Substrat über das Verbindungsmaterial;
wodurch dem Verbindungsmaterial ermöglicht wird, zu härten, und anschließend
das erste Substrat mit dem zweiten Substrat zu verschmelzen.

13. Verfahren zum Einbetten von diskreten elektrischen Schaltelementen in einem Mehrschichtmodul nach Anspruch 12, wobei das Anbringen des ersten diskreten elektrischen Schaltelements an dem ersten Substrat das Nanosilber-Sintern des ersten diskreten elektrischen Schaltelements an das erste Substrat umfasst.

14. Verfahren zum Einbetten von diskreten elektrischen Schaltelementen in einem Mehrschichtmodul nach Anspruch 13, wobei das Anbringen des ersten diskreten elektrischen Schaltelements an dem ersten Substrat eine transiente Flüssigphasenverbindung umfasst, die das erste diskrete elektrische Schaltelement mit dem ersten Substrat verbindet.

## Revendications

1. Ensemble électronique multicouche, comprenant :
une pluralité de couches de substrat empilées, chacune de la pluralité de couches de substrat étant liée par fusion à au moins l'une adjacente de la pluralité de couches de substrat ;
un premier composant de circuit électrique discret lié à une première couche de la pluralité de couches en utilisant un matériau de liaison interposé entre le composant de circuit électrique discret et la première couche et formant un joint à brasure tendre interfacial ayant une température de refusion > 900 °C, la température de refusion à laquelle le matériau de liaison devient fluide étant supérieure à chacune d'une température d'écoulement initiale du matériau de liaison et d'une température de liaison par fusion des couches de substrat, la température d'écoulement initiale du matériau de liaison étant la température à laquelle le matériau de liaison est devenu fluide pour lier le composant de circuit électrique discret et la première couche avant la liaison par fusion des couches de substrat ;
une pluralité de trous d'aération (122) configurée pour permettre de manière fonctionnelle à des gaz de s'échapper pendant une liaison du premier composant électrique discret et de la première couche.

2. Ensemble électronique multicouche selon la revendication 1, comprenant en outre :
un second composant de circuit électrique discret lié à une seconde couche de la pluralité de couches.

3. Ensemble électronique multicouche selon la revendication 2, dans lequel la pluralité de couches de substrat est empilée dans une première direction, et le premier composant électrique discret chevauche le second composant électrique discret dans la première direction.

4. Ensemble électronique multicouche selon la revendication 1, dans lequel la pluralité de couches de substrat est empilée dans une première direction, et le premier composant de circuit électrique discret est positionné entre des couches adjacentes de la pluralité de couches de substrat empilées.

5. Ensemble électronique multicouche selon la revendication 1, dans lequel les couches de substrat incluent un composite fluoropolymère.

6. Ensemble électronique multicouche selon la revendication 1, dans lequel le matériau de liaison est un solide immédiatement avant que la température de refusion ne soit atteinte.

7. Ensemble électronique multicouche selon la revendication 1, dans lequel le matériau de liaison est une brasure frittée au nanoargent.

8. Ensemble électronique multicouche selon la revendication 1, dans lequel le matériau de liaison est un alliage lié en phase liquide transitoire.

9. Ensemble électronique multicouche selon la revendication 1, dans lequel le premier composant de circuit électrique discret est l'un parmi une résistance discrète passive, un condensateur, un dispositif magnétique, et un dispositif à semi-conducteur actif.

10. Ensemble électronique multicouche selon la revendication 1, dans lequel l'une de la pluralité de couches de substrat empilées est un substrat primaire, un semi-conducteur de puissance est lié par puce au substrat primaire, et les autres couches de substrat sont empilées sur le premier substrat, et dans lequel un composant électronique actif est fixé à une surface externe de l'une de la pluralité de couches de substrat qui est positionnée la plus à l'écart du substrat primaire.

11. Ensemble électronique multicouche selon la revendication 10, dans lequel le matériau de liaison interposé entre le composant de circuit électrique discret et la première couche est un premier matériau qui a un premier point de fusion qui supérieur à la température de liaison par fusion des couches de substrat, et dans lequel l'ensemble électronique multicouche comprend en outre un second composant de circuit électrique discret lié à une seconde couche de la pluralité de couches de substrat avec un second matériau qui a un second point de fusion qui est supérieur à la température de liaison par fusion des couches de substrat.

12. Procédé d'intégration de composants de circuit électrique discrets à l'intérieur d'un module multicouche, comprenant :
la fixation d'un premier composant de circuit électrique discret à un premier substrat par l'intermédiaire d'un matériau de liaison qui est initialement fluide à une première température amenant ainsi le matériau de liaison à passer par une transition d'état de sorte que, une fois que le matériau de liaison durcit, le matériau de liaison ne revienne pas à un état fluide jusqu'à ce qu'une seconde température, qui est supérieure à la première température, ne soit atteinte, la première température est inférieure à une température de liaison par fusion du premier substrat, et la seconde température est > 900 °C et supérieure à la température de liaison par fusion du premier substrat ;
la fixation d'un second composant de circuit électrique discret à un second substrat par l'intermédiaire du matériau de liaison ;
le fait de laisser le matériau de liaison durcir, et ensuite
la liaison par fusion du premier substrat au second substrat.

13. Procédé d'intégration de composants de circuit électrique discrets à l'intérieur d'un module multicouche selon la revendication 12, dans lequel la fixation du premier composant de circuit électrique discret à un premier substrat inclut le frittage au nanoargent du premier composant de circuit électrique discret au premier substrat.

14. Procédé d'intégration de composants de circuit électrique discrets à l'intérieur d'un module multicouche selon la revendication 13, dans lequel la fixation du premier composant de circuit électrique discret au premier substrat inclut une liaison en phase liquide transitoire du premier composant de circuit électrique discret au premier substrat.
